(19)

Europäisches
Patentamt
European
Patent Office
Office européen
des brevets

(11)  **EP 2 581 753 A1**

(12)  **EUROPEAN PATENT APPLICATION**

(43) Date of publication:
**17.04.2013  Bulletin 2013/16**

(51) Int Cl.:
***G01R 31/327*** (2006.01)

(21) Application number: **12187661.9**

(22) Date of filing: **08.10.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **14.10.2011  US 201113273685**

(71) Applicant: **General Electric Company
Schenectady, NY 12345 (US)**

(72) Inventors:
 • **Mahalingam, Sakethraman
  Niskayuna, NY 12309 (US)**

 • **Valdes, Marcelo
  Niskayuna, NY 12309 (US)**
 • **Asokan, Thangavelu
  Niskayuna, NY 12309 (US)**
 • **May, Andrew
  Niskayuna, NY 12309 (US)**

(74) Representative: **Picker, Madeline Margaret
 Global Patent Operation - Europe
 GE International Inc.
 15 John Adam Street
 London WC2N 6JU (GB)**

(54)  **Systems and methods for monitoring electrical contacts**

(57)    Systems and methods for monitoring electrical contacts are provided. One method includes calculating an impedance of an electrical contact based on an electrical signal applied to the electrical contact and a measured electrical signal after passing through the electrical contact. The method also includes determining a condition of the electrical contact using the calculated impedance.

FIG. 1

**Description**

BACKGROUND

The subject matter disclosed herein relates generally to electrical contacts, and more particularly to systems and methods for monitoring electrical contacts on a continuous or periodic basis.

Electrical connections typically have a useful life. Over time, the contacts of the electrical connections can degrade, which can result in the partial or total loss of the functioning of the connections. The contacts can also degrade suddenly after an operation of the device. If not effectively monitored, the degradation of these connections within different components can adversely affect the performance characteristics of these components and reduce the reliability of associated systems. To maintain adequate performance of an electrical system, the components are often monitored along with system performance to determine if some type of maintenance, repair or replacement action should be taken. Components may be monitored continuously or via periodic prophylactic examinations consisting of visual inspection or a series of test using appropriate instruments. The gradual degradation of contact surfaces can cause conduction problems resulting in local temperature rise, which may affect system performance, and lead to further degradation. Contacts can also degrade suddenly from a single, or few operations under extremely adverse conditions. The degree of degradation is often not obvious to the user and whether the device can be put back into useful operation cannot be easily determined. This then requires a battery of manual tests and close observation after putting the device back in service, or the device is replaced "just in case".

In some conventional electrical contact monitoring systems, the determination of the contact condition of circuit breakers is by means that connect special instruments designed for low resistance measurement to the contacts (to provide a line test of low resistance) or using infrared scans to provide online measuring of temperature.

These conventional electrical contact monitoring systems may not satisfactorily identify the degradation of the electrical contacts, such as a progressive degradation of the electrical contacts. Accordingly, late detection or poor sensitivity may result when using these systems.

BRIEF DESCRIPTION

In accordance with one embodiment, a method is provided that includes_calculating an impedance of an electrical contact based on an electrical signal applied to the electrical contact and a measured electrical signal after passing through the electrical contact. The method also includes determining a condition of the electrical contact using the calculated impedance.

In accordance with another embodiment, a system is provided that includes a receiving unit configured to receive electrical signal information, the electrical signal information including information for an electrical signal applied to an electrical contact and a measured electrical signal after passing through the electrical contact. The system also includes a processing unit configured to calculate an impedance of the electrical contact using the measured electrical signal information to determine a condition of the electrical contact.

In accordance with still another embodiment, a circuit breaker is provided that includes one or more pairs of contacts and a signal generator for generating an electrical signal having at least one frequency, wherein the electrical signal is applied to the pair(s) of contacts. The circuit breaker also includes a processing unit configured to measure the applied electrical signal after the signal passes through the pair(s) of contacts and determine a change between the applied electrical signal and the measured electrical signal. The processing unit is further configured to determine an impedance of the contacts using the determined to determine a condition of the pair(s) of contacts.

BRIEF DESCRIPTION OF THE DRAWINGS

The drawings, in which like numerals represent similar parts, illustrate generally, by way of example, but not by way of limitation, various embodiments discussed in the present document.

Figure 1 is a schematic diagram of an electrical contact monitoring system in accordance with an embodiment.

Figure 2 is a graph illustrating spectroscopic resistance signatures of a contact pair.

Figure 3 is a graph illustrating spectroscopic reactance signatures of a contact pair.

Figure 4 is a graph of time plots of a modulus of contact impedance at different frequencies.

Figure 5 is a graph of time plots of a phase angle at different frequencies

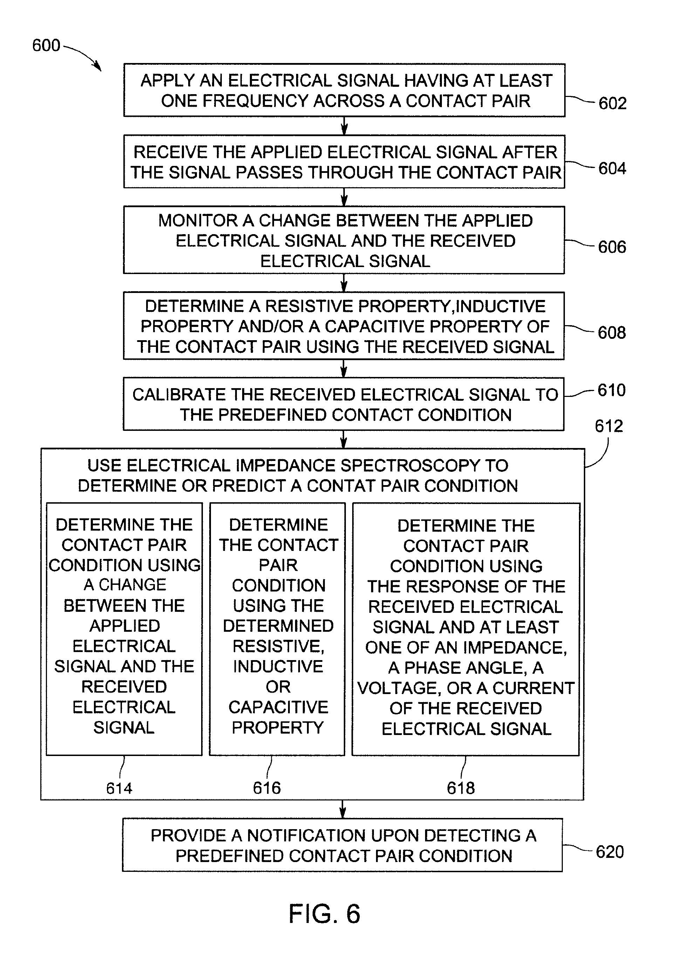

Figure 6 is a flowchart of a method for monitoring electrical contacts in accordance with an embodiment.

DETAILED DESCRIPTION

The foregoing summary, as well as the following detailed description of certain embodiments of the subject matter set forth herein, will be better understood when read in conjunction with the appended drawings. As used herein, an element or step recited in the singular and proceeded with the word "a" or "an" should be understood as not excluding plural of said elements or steps, unless such exclusion is explicitly stated. Furthermore, references to "one embodiment" are not intended to be interpreted as excluding the existence of additional embodiments that also incorporate the recited features. Moreover, unless explicitly stated to the contrary, embodiments "comprising" or "having" an element or a plurality of elements having a particular property may include additional such elements not having that property.

In the following detailed description, reference is made to the accompanying drawings which form a part hereof, and in which are shown by way of illustration specific embodiments in which the subject matter disclosed herein may be practiced. It is to be understood that the embodiments may be combined or that other embodiments may be utilized, and that structural, logical, and electrical variations may be made without departing from the scope of the subject matter disclosed herein. The following detailed description is, therefore, not to be taken in a limiting sense, and the scope of the subject matter disclosed herein is defined by the appended claims and their equivalents. In the description that follows, like numerals or reference designators will be used to refer to like parts or elements throughout. In this document, the terms "a" or "an" are used to include one or more than one and the term "or" is used to refer to a nonexclusive "or", unless otherwise indicated.

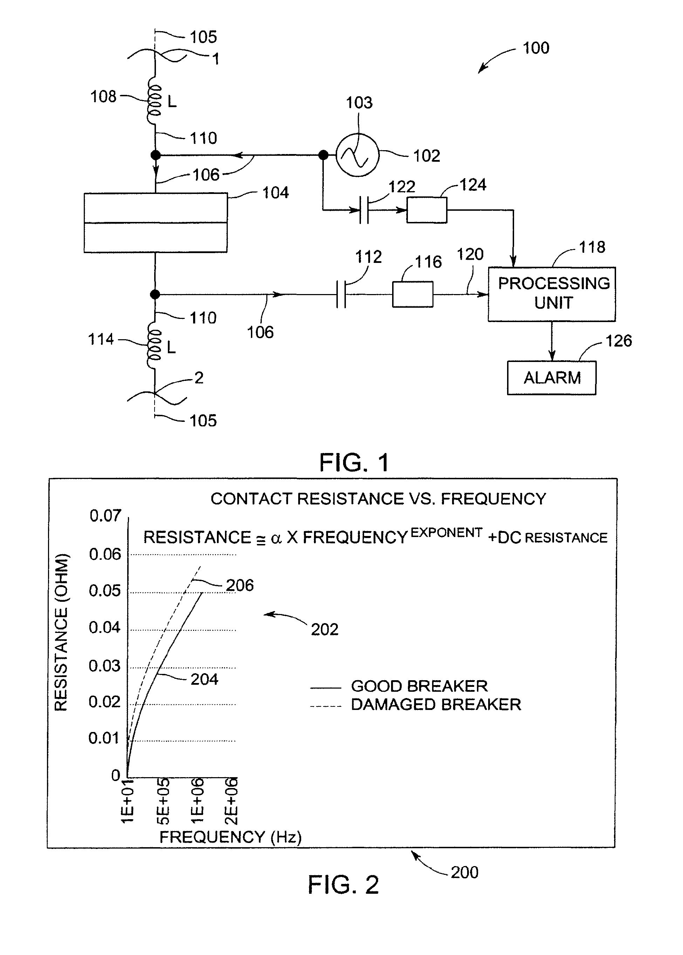

Figure 1 illustrates a schematic diagram of an electrical contact monitoring system 100 in accordance with an embodiment. The electrical contact monitoring system 100 may be a stand alone monitoring system. Alternatively, the electrical contact monitoring system 100 may form part of another system. For example the electrical contact monitoring system 100 may form part of a circuit breaker system or be embodied in a circuit breaker to form a "smart" circuit breaker. The electrical contact monitoring system 100 may monitor the condition of a plurality of circuit breakers, which may be of different types (e.g., air assisted circuit breaker, vacuum assisted circuit breaker or gas assisted circuit breaker). It should be noted that the various embodiments may be used in connection with contacts for other devices. For example, the various embodiments may be implemented with bus to bus connections, cable to bus connections or circuit breaker to equipment connections, among others. It also should be noted that different embodiments or measurements may be used for different applications or for different devices.

The electrical contact monitoring system 100 includes a signal generator 102 (e.g., an alternating signal generator) that generates an electrical signal 103 at one or more frequencies. In one embodiment, the signal generator 102 generates the electrical signal 103, which is applied across an electrical contact, illustrated as a contact pair 104 (e.g., a contact pair of a circuit breaker) and wherein the electrical signal 103 includes one or more frequencies.

The contact pair 104, in various embodiments, forms a part of a circuit 105, for example, an electrical circuit (not shown) beyond points 1 and point 2 as shown in Figure 1. For example, the circuit 105 may be a smart grid that is used for power distribution and the like. As another example, the circuit 105 may form part of a power conversion system of a wind or a solar power generation plant and the like. However, it should be noted that these are merely examples and the contact pair 104 may form part of any electrical circuit.

The contact pair 104 is any device capable of providing electrical contact such that an electrical path or connection is provided. For example, the contact pair 104 may be any suitable electrical contacts employed in relays or switches.

In operation, in one embodiment, the signal generator 102 generates an electrical signal 103 having a single frequency signal. In other embodiments, the signal generator 102 generates an electrical signal 103 having a frequency range that includes a plurality of different frequencies. For example, the signal generator 102 may generate an electrical signal 103 with a frequency range that is between 1 kHz to 1 MHz. Accordingly, the signal generator 102 may generate an electrical signal 103 with a single frequency or multiple frequencies between 1 kHz to 1 MHz and the like. However, other ranges are contemplated. For example, the signal generator 102 may generate an electrical signal 103 with frequencies up to 20 MHz. It should be noted that the one or more frequencies may be based on a particular contact condition to be monitored or identified. In various embodiments, the frequency of the electrical signal 103 is a higher frequency than a supply frequency for the circuit 105.

The electrical signal 103 may be different types of signals. In one embodiment, the electrical signal 103, which is applied across the contact pair 104, is an alternating current signal. For example, the alternating current signal may have a current value up to 100 Ampere (A). The electrical signal 103 also may have different voltages, for example, a voltage up to 10 Volts. Again, the current and voltage of the electrical signal 103 may be higher or lower, such as based on the particular application.

The electrical signal 103 generated by the signal generator 102 (illustrated by the arrows showing electrical flow 106) to the contact pair 104, which includes the electrical contacts under inspection or that are being monitored. In one embodiment, to limit or prevent the flow 106 of the electrical signal 103 from leaking into the circuit 105 and to direct the flow 106 through the contact pair 104, an inductor 108 may be provided to the circuit 105. For example, the inductor 108 may be positioned within the circuit 105 before the contact pair 104 (toward Point 1 in Figure 1) such that the signal generator 102 is connected to the circuit 105 between the inductor 108 and the contact pair 104. In an alternate embodiment, or additionally, the inherent inductance of a transmission line 110 may limit or prevent the electrical signal 103 from leaking into the circuit 105.

In various embodiments, the generated electrical signal 103 is periodically injected through (or applied to) the contact pair 104. The electrical signal 103 may be injected at predetermined intervals, which may be fixed or variable. The electrical signal 103 also may be applied continuously during some or all of the period when the contact pair 104 is being monitored. When the electrical signal 103 passes through the contact pair 104, the resulting measured signal at one or more frequencies may vary with the surface condition of the contact pair 104. For example, different surface conditions of the contact pair 104 may affect the response of the electrical signal 103 at different frequencies, such as pitting, dust deposits, roughness of the surface of the contact pair 104, carbon deposits, sulphide corrosion, rust, moisture, decay, deterioration, and/or oxidation, among others. In various embodiments, the response, such as the resulting or measured electrical signal is used to determine and identify the surface condition of the contact pair 104. For example, based on the injected frequencies and the measured responses, electrical impedance spectroscopy (EIS) as described in more detail herein, may be used to determine the particular condition (and the extent of the condition) affecting the surface of the contact pair 104. For example, variations or changes in the impedance of the measured signal at one or more frequencies may be analyzed to determine a condition of the contact pair 104.

In one embodiment, a blocking capacitor 112 also is provided to limit or prevent the in-situ operational current of the circuit 105 from leaking into the electrical contact monitoring system 100. However, the blocking capacitor 112 also allows the electrical signal 103 generated by the signal generator 102 to pass therethrough. To limit or prevent the electrical signal 103 from leaking into the circuit 105 after the electrical signal 103 passes through the contact pair 104, an inductor 114 may be added to the circuit 105. The inductor 114 may be positioned in the circuit 105 after the contact pair 104 (toward Point 2 in Figure 1) such that the blocking capacitor 112 is connected to the circuit 105 between the inductor 114 and the contact pair 104. In an alternate embodiment, or additionally, the inherent inductance of the transmission line 110 may limit or prevent the electrical signal 103 from leaking into the circuit 105.

Additionally, a current sensor 116 is provided in some embodiment where the applied electrical signal 103 is a voltage applied across the electrical contact pair 104 and a resulting electrical current is measured. In one embodiment, the applied electrical signal 103 may be a current signal and the current sensor 116 measures the applied current signal. The measurement by the current sensor 116, when the applied electrical signal 103 is a current, may be used as a feedback to the signal generator 102 to tune or calibrate the applied electrical signal 103, such as to a predetermined value. In another embodiment, the feedback may be used to monitor the functioning of a blocking capacitor 112 to prevent in-situ current from leaking to a processing unit 118. For example, when the current sensor 116 detects a high input current leaking into the electrical contact monitoring system 100, the current sensor 116 may break circuit connectivity and provide an alarm (e.g., an audible or visible alarm to an operator).

Thus, an electrical signal, as the applied electrical signal 103 passes through the contact pair 104 (and in some cases the current sensor 116), and an electrical signal 120 is measured (also referred to as a measured electrical signal) in response thereto, which may be provided as an input to the processing unit 118 for processing, such as to perform contact condition detection. The processing unit 118 may be any type of processor or computing machine, which may be embodied in hardware, software or a combination thereof. It should be noted that the processing unit 118 may include a receiving unit (or other receiver) to receive the electrical signal 120 (or information relating to the electrical signal 120), as well as other signals or data, for example, the frequency and value of the applied electrical signal 103.

For example, the processing unit 118 also receives the electrical signal 103 generated by the signal generator 102. In this signal path, another blocking capacitor 122 and current sensor 124 may be used to limit or prevent the in-situ operational current of the circuit 105 from leaking to the processing unit 118. The operation of the blocking capacitor 122 and current sensor 124 are similar to the operation of the blocking capacitor 112 and current sensor 116 as described above.

In one embodiment, the processing unit 118 analyzes the received signals, namely the electrical signals 103 and 120 using EIS techniques to determine one or more contact conditions. For example, the processing unit 118 may analyze the received signals to monitor changes between the applied signal and the resulting measured signal at one or more frequencies, for example, between the applied electrical signal 103 and the electrical signal 120. In one embodiment, the processing unit 118 may be calibrated to an original contact pair 104 condition, that is, the surface condition of the contact pair existing when the contact pair 104 is new. The applied electrical signal 103 may also be used to calibrate the processing unit 118. Alternatively, the processing unit 118 may be calibrated for other contact conditions or any other factor. The calibration of the processing unit 118 in some embodiments allows the electrical contact monitoring system 100 to reduce or avoid false positives in identifying or predicting contact pair 104 conditions by defining a baseline measurement. The processing unit 118 may also be used to compute the real part of the impedance and the imaginary part of the impedance from the applied electrical signal 103 and the measured electrical signal 120.

Thus, in various embodiments, the electrical signal 103 is applied across electrical contacts, for example, the contact pair 104, as an applied electrical signal. The applied electrical signal 103 has at least one frequency. A response is then measured or monitored, for example, the electrical signal 120, which is a measured electrical signal, and is measured as the applied electrical signal 103 passes through the electrical contact. The processing unit 118 then may use the applied and measured signals at different frequencies to determine a condition of the contact pair 104. In various embodiments, the processing unit 118 may calculate an impedance, for example, a complex impedance including at least one of a resistive property, a capacitive property or an inductive property of the electrical contact at one or more frequencies as described in more detail herein to determine a condition of the electrical contact. For example, the applied electrical signal 103 may be an electrical voltage signal and the measured electrical signal 120 may be an electrical current. In other embodiments, the applied electrical signal 103 may be an electrical current signal and the resulting electrical voltage measured.

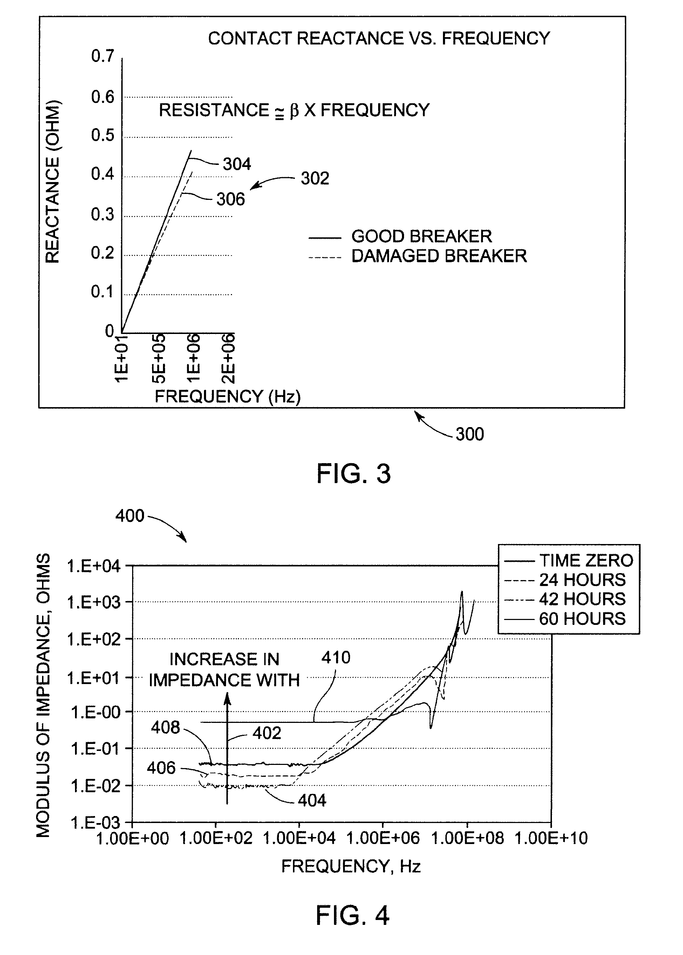

Figure 2 is a graph 200 illustrating, with spectroscopic contact resistance signatures 202, a curve 204 that is a resistance plot of a new or good breaker or contact and a curve 206 that is a resistance plot of a damaged breaker or contact, both over a frequency range. Figure 3 is a graph 300 illustrating, with spectroscopic contact reactance signatures 302, a curve 304 that is a reactance plot of a new or good breaker or contact and a curve 306 that is a reactance plot of a damaged breaker or contact, both over a frequency range. The graphs 200 and 300 are for a single breaker or contact, but similar graphs may be plotted for multiple breakers or contacts. In various embodiments, electrical model parameters may be extracted from the impedance data to, for example, quantify the degradation state of breaker contacts. It should be noted that resistance in the real part of the complex impedance and reactance is the imaginary part of the complex impedance. Additionally, the frequency is the frequency of the injected signals at which the impedance is measured.

In various embodiments, the processing unit 118 may analyze the spectroscopic signatures of the contact pair 104 to determine different contact conditions. For example, the processing unit 118 may determine a resistive property, a capacitive property or an inductive property of the contact pair using the electrical signal 120 to identify a particular contact condition corresponding to the signature of the electrical signal 120. For example, multiple points along one or more curves may be analyzed or compared or a morphology type analysis may be performed. It should be noted that a capacitance spectroscopy of a new contact pair may include both a contact pair resistance and an air capacitance.

When the contact pair 104 is in use, the contact pair 104 generally experiences a continuous time dependant degradation of the contact pair material, such that the impedance spectroscopy of the contact pair 104 may include a resistance, capacitance and/or inductance due to the surface condition of the contact pair 104. The change in signature of the electrical signal 120 correlates or corresponds to different types and levels of degradation of the contact pair 104.

For example, the signature of the electrical signal 120 after a period of use may have a capacitive signature with an increased resistance. In one embodiment, the capacitive property of the contact pair 104 may be calculated such that the capacitive property includes a combination of a real capacitive part and an imaginary capacitive part. The capacitance of the contact pair 104 may be represented by the following equation:

$$Z = R + jXc \qquad\qquad \text{Equation 1}$$

where Z represents a total capacitance for the contact pair 104, R represents the real capacitive part, and Xc represents the imaginary capacitive part.

Alternatively, an impedance plot of the response of the contact pair 104 may be used. The signature of the electrical signal 120 after a period of use has an inductance signature with an increased resistance. In one embodiment, the inductance property of the contact pair 104 may be calculated such that the inductance property includes a combination of a real inductive part and an imaginary inductance part. The inductance of the contact pair 104 may be represented by the following equation:

$$L = Rl + jXl \qquad\qquad \text{Equation 2}$$

where L represents a total inductance for the contact pair 104, Rl represents the real inductance part, and Xl represents the imaginary inductance part.

Referring again to Figure 1, in one embodiment, the processing unit 118 may store a plurality of signatures at different frequencies or ranges of frequencies corresponding to different surface conditions, which may be based on the frequency injected and/or the particular contact pair 104 being monitored. It should be noted that the predetermined signatures may be determined from previous testing, which may include real testing (such as using a plurality of previous results from similar types of contact pairs) or simulations. Alternatively, the processing unit 118 may store predetermined criteria or different signatures defining or corresponding to different stages or levels of the plurality of surface conditions. Thus, using EIS and the signature(s), the processing unit 118 may identify or predict one or more contact pair conditions (e.g., degraded surface conditions). In another embodiment, the processing unit 118 may use only the differences between the applied electrical signal 103 and the measured electrical signal 120 to determine one or more conditions.

Figure 4 is a graph 400 illustrating one example of a plurality of time plots showing a relationship between a modulus of contact impedance and a frequency of an applied electrical signal (in Hertz). It should be noted that the impedance at each frequency of measurement (rather than time domain), which is the ratio of the voltage to the current at the same frequency is shown. As such, the impedance spectrum analysis shown in Figure 4 illustrates the impedance measurements in the frequency domain. The plots 404, 406, 408 and 410 correspond to measured data at times zero, 24 hours, 42 hours, and 60 hours for an accelerated aging of silver contacts by hydrogen sulfide (H2S). The data are shown for an applied electrical signal 103 with a frequency range from 1 Hz to 1.00E + 09 Hz. The line 402 illustrates the increase in the impedance for the silver contact pair over a zero to sixty hours time period. As can be seen, the impedance increases with the increase of degradation of the contact pair 104. The plots 404, 406, 408 and 410 simply illustrate the degradation of the contact pairs 104 over time. Thus, using different spectroscopic impedance signatures, one or more contact pair conditions and the extent or level of the condition may be determined.

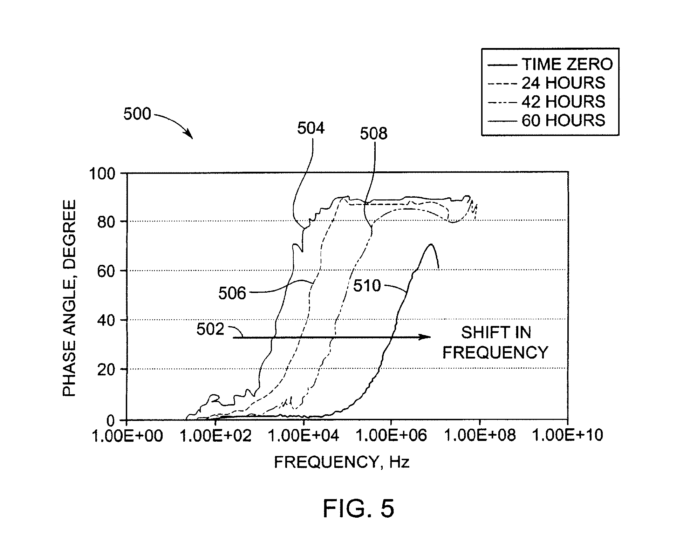

Figure 5 is a graph 500 illustrating one example of a plurality of time plots showing a relationship between the phase angle of a measured electrical signal (e.g., the electrical signal 120) and a frequency (in Hertz) of an applied electrical signal (e.g., the electrical signal 103). Figure 5 also illustrates the frequency shift between the applied signal and the received signal for a given phase angle over time. The plots 504, 506, 508 and 510 correspond to measured data at times zero, 24 hours, 42 hours, and 60 hours, again for an accelerated aging of silver contacts by H2S. The data are shown for an applied electrical signal 103 with a frequency range from 1Hz to 1.00E + 09 Hz. The line 502 illustrates that for a constant phase value, the frequency spectrum shifts as the contact pair 104 degrades. Thus, using different spectroscopic signatures, one or more contact pair conditions and the extent or level of the condition may be determined.

In various embodiments, the processing unit 118 analyzes the received signal at one or more frequencies as generally illustrated in Figures 4 and 5. For example, the processing unit 118 in determining at least one contact pair condition may use the response of the received signal and at least one of an impedance, a phase angle, a voltage, or a current of the received signal, and combinations thereof. In another embodiment, the processing unit 118 may determine at least one contact pair condition based on the determined resistive property, the determined inductive property or the determined capacitive property of the contact pair 104 under inspection or being monitored.

In various embodiments, the processing unit 118 may also predict the condition of the contact pair 104 based on a predefined model, wherein the predefined model includes using at least one of the frequency, impedance, phase angle, voltage, or a current of the measured electrical signal 120. In some cases, the processing unit 118 may predict the contact pair 104 condition based on a predefined model, wherein the model is created using different voltage signals, wherein the signal has a frequency range or may have a single frequency, and an EIS phase response of the received signal in relation to the applied signal using data such as shown in Figures 4 and 5.

In one embodiment, the processing unit 118 may indicate a progressive degradation of the contact pair 104 using at least one of the response of the measured electrical signal 120, an impedance of the measured electrical signal 120, a phase angle of the measured electrical signal 120, a voltage of the measured electrical signal 120, or a current of the measured electrical signal 120. For example, as the contact pair 104 degrades, the EIS phase angle of the measured electrical signal 120 decreases, which may be determined using any suitable EIS analysis technique (e.g., comparing a measured response to a predicted response from a forward model). Using the results of the change in the phase angle of the EIS of the contact pair 104, the processing unit determines the progressive degradation or damage to the contact pair 104 based on, for example, a point along the spectroscopic impedance signature curve or a comparison with predicted values.

The various embodiments may provide a notification of a particular contact pair condition or level of degradation. For example, returning to Figure 1, the processing unit 118, upon determining and/or predicting at least one contact pair condition (e.g., a predefined condition), may provide a notification of that information, for example, an alarm 126 that informs a user of the electrical contact monitoring system 100 of the condition of the contact pair 104. The alarm 126 may be provided using any type of notifying technology. For example, the alarm 126 may be a text message to the user's cell phone. The alarm 126 may a sound and/or light signal. Also, the alarm 126 may be provided as an e-mail message sent with an indication representing the condition of the contact pair 104 (e.g., numbers representing whether the contact pair 104 needs to be replaced soon). Alternatively, the alarm 126 may be any of text, sound, light, electronic signal, e-mail or a combination thereof.

The information provided by the processing unit 118 may be an analog or a digital signal. The signal may be communicated over a wired or a wireless network. The processing unit 118 may transmit the information to a central monitoring location wherein similar signals are received from a plurality of monitored contact pairs 104 of a plurality of electrical contact monitoring systems 100. In another embodiment, the processor 118 may transmit the measured electrical signal 120 to a central monitoring location, wherein the measured electrical signal 120 may be used for further processing, such as to notify a technician that a circuit breaker needs to be changed. Alternatively, the electrical signal 120 may be sent to another system. For example, the other system may be a circuit breaker switch system.

The electrical contact monitoring system 100 also may be used when the circuit 105 is off-line. The circuit 105 may be off-line when the circuit 105 is not operating and/or has no electrical current. Alternatively, the electrical contact monitoring system 100 may be used when the circuit 105 is in-situ operation or is a live circuit. A circuit is in-situ or a circuit is live when the circuit is operatively connected to a power source.

In some embodiments, the electrical contact monitoring system 100 may simultaneously or concurrently monitor multiple contact pairs 104. For example, the contact pair 104 may be connected in a series or parallel connection with a plurality of other contact pairs 104. In an arrangement for monitoring the operation of a plurality of contact pairs 104 connected in parallel, wherein each contact pair 104 may have a substantially different impedance when the contacts are closed, a separate electrical contact monitoring system 100 may be provided for connection with each such plurality of contact pairs 104. A single electrical contact monitoring system 100 may simultaneously or concurrently monitor a plurality of circuits with each of the plurality of circuit having a plurality of contact pairs 104. The electrical contact monitoring system 100 may monitor the plurality of contact pairs 104 and report a combined result of the condition of all or a subset of the contact pairs 104.

Figure 7 illustrates a method 600 for monitoring electrical contacts in accordance with various embodiments. In one embodiment, the method 700 includes analyzing at least one electrical contact pair, such as the electrical contact pair 104 (shown in Figure 1). In particular, at 602, an electrical signal, for example, the electrical signal 103, is applied across the contact pair, wherein the electrical signal has at least one frequency (e.g., a frequency modulated electrical signal). The electrical signal, in one embodiment, may be generated using a signal generator that generates an alternating electrical signal. Then, at 604, a response to the applied electrical signal is measured after the signal passes through the contact pair. It should be noted that the measured signal may pass through one or more blocking capacitors to limit or prevent the in-situ operational current of the circuit from leaking into a processing portion and affecting the method 600. The measured signal passes through one or more inductors used to limit or prevent the applied electrical signal from leaking into the processing portion and affecting the method 600. Alternatively or additionally, the inherent inductance of the transmission line communicating the signal limits or prevents the electrical signal 103 from leaking into the processing portion and affecting the method 700.

At 606, a change between the applied electrical signal and the measured electrical signal, for example the electrical signal 120, is monitored. The monitoring of the change may be at multiple frequencies, for example, using the processing unit 118. Then at 608, at least one of a resistive property, an inductive property and/or a capacitive property of the contact pair is determined using the measured electrical signal that includes one or more frequency components that may be separated using any suitable signal frequency separation technique.

At 610, the measured electrical signal may be calibrated to a predefined contact pair condition. For example, the surface condition of the contact pair existing when the contact pair is new may be used for calibration, namely to set baseline measurements and a frequency response. The applied electrical signal may be used for calibration to limit or avoid a false positive determination of the contact pair condition as described herein.

Thereafter, at 612, at least one contact pair condition is determined or predicted using EIS. For example, the contact pair condition may be one of pitting, dust deposits, roughness of the surface of the contact pair, carbon deposits, sulphide corrosion, rust, moisture, decay, deterioration, and/or oxidation, among others.

The EIS analysis may include one or more different determinations at steps 614, 616 and/or 618. For example, in a new contact pair, an impedance spectroscopy includes mainly contact pair resistance and an air capacitive property. However, in a contact pair that is not new an impedance spectroscopy may include a contact pair resistance and a capacitive property due to the surface conditions of the contacts. It should be noted that the capacitive property may include a combination of a real capacitive part and an imaginary capacitive part as described herein.

Thus, at 614 at least one condition of the contact pair may be determined using a change between the applied electrical signal and the measured electrical signal. Additionally or alternatively, at least one condition may be determined using the determined resistive property, a determined inductive property or a determined capacitive property at 616. At least one condition may be determined at 618 using the response of the measured electrical signal, the contact impedance, a phase angle, a voltage, or a current of the measured electrical signal or any combination thereof. For example, as described herein, these determinations may be based on spectroscopic impedance signatures or predicted values, among other information.

It should be noted that the determination may be of a present state of the contact pair or may include indicating a progressive degradation of the contact pair, such as based on a position of the current measurement along a spectroscopic impedance signatures curve

The method 600 may be performed off-line when the circuit having the monitored contact pair is not in an operating state. Alternatively, the method 600 may be performed in-situ wherein the contact pair is operatively connected within the circuit.

The determination may be made based on a single frequency response or a multiple frequency response, which may correspond to one or more monitored contact pairs. The responses may be compared to predetermined or modeled responses to identify a particular condition or the level of the condition.

Once the various determinations are made with respect to the condition of contact pair, at 620 a notification may be provided upon detecting at least one predefined contact pair condition. For example, the condition might indicate that the contact pair is within ten percent of an overall useful life based upon a position along a predicted curve. The notification, as well as general monitoring information, may be transmitted to a central monitoring location, wherein the information is processed for various contact pair conditions. Thus, the determination may be made locally or remotely.

In various embodiments, determining the impedance includes determining one or more, or at least two, of a resistive property, an inductive property or a capacitive property, at one or more frequencies. In some embodiments, the voltage and current are combined at multiple frequencies. In some embodiments, plots of resistance, capacitance and/or inductance as a function of frequency are used, for example, to determine a change or shift in a plotted curve. Also, the signature of degradation may be analyzed using the measured or resulting signals only, or bother the applied and measured signals.

At least one technical effect of various embodiments is an improved determination of the condition of a contact and/or an improved ability to predict the condition of a contact.

The various embodiments and/or components, for example, the modules, elements, or components and controllers therein, also may be implemented as part of one or more computers or processors. The computer or processor may include a computing device, an input device, a display unit and an interface, for example, for accessing the Internet. The computer or processor may include a microprocessor. The microprocessor may be connected to a communication bus. The computer or processor may also include a memory. The memory may include Random Access Memory (RAM) and Read Only Memory (ROM). The computer or processor further may include a storage device, which may be a hard disk drive or a removable storage drive such as an optical disk drive, solid state disk drive (e.g., flash RAM), and the like. The storage device may also be other similar means for loading computer programs or other instructions into the computer or processor.

As used herein, the term "computer" or "module" may include any processor-based or microprocessor-based system including systems using microcontrollers, reduced instruction set computers (RISC), application specific integrated circuits (ASICs), field-programmable gate arrays (FPGAs), graphical processing units (GPUs), logic circuits, and any other circuit or processor capable of executing the functions described herein. The above represent examples only, and are thus not intended to limit in any way the definition and/or meaning of the term "computer".

The computer or processor executes a set of instructions that are stored in one or more storage elements, in order to process input data. The storage elements may also store data or other information as desired or needed. The storage element may be in the form of an information source or a physical memory element within a processing machine.

The set of instructions may include various commands that instruct the computer or processor as a processing machine to perform specific operations such as the methods and processes of the various embodiments of the invention. The set of instructions may be in the form of a software program, which may form part of a tangible non-transitory computer readable medium or media. The software may be in various forms such as system software or application software. Further, the software may be in the form of a collection of separate programs or modules, a program module within a larger program or a portion of a program module. The software also may include modular programming in the form of object-oriented programming. The processing of input data by the processing machine may be in response to operator commands, or in response to results of previous processing, or in response to a request made by another processing machine.

As used herein, the terms "software", "firmware" and "algorithm" are interchangeable, and include any computer program stored in memory for execution by a computer, including RAM memory, ROM memory, EPROM memory, EEPROM memory, and non-volatile RAM (NVRAM) memory. The above memory types are exemplary only, and are thus not limiting as to the types of memory usable for storage of a computer program.

It is to be understood that the above description is intended to be illustrative, and not restrictive. For example, the above-described embodiments (and/or aspects thereof) may be used in combination with each other. In addition, many modifications may be made to adapt a particular situation or material to the teachings of the various embodiments of the invention without departing from their scope. While the dimensions and types of materials described herein are intended to define the parameters of the various embodiments of the invention, the embodiments are by no means limiting and are exemplary embodiments. Many other embodiments will be apparent to those of skill in the art upon reviewing the above description. The scope of the various embodiments of the invention should, therefore, be determined with reference to the appended claims, along with the full scope of equivalents to which such claims are entitled. In the appended claims, the terms "including" and "in which" are used as the plain-English equivalents of the respective terms "comprising" and "wherein." Moreover, in the following claims, the terms "first," "second," and "third," etc. are used merely as labels, and are not intended to impose numerical requirements on their objects.

This written description uses examples to disclose the various embodiments of the invention, including the best mode, and also to enable any person skilled in the art to practice the various embodiments of the invention, including making and using any devices or systems and performing any incorporated methods. The patentable scope of the various embodiments of the invention is defined by the claims, and may include other examples that occur to those skilled in the art. Such other examples are intended to be within the scope of the claims if the examples have structural elements that do not differ from the literal language of the claims, or if the examples include equivalent structural elements with insubstantial differences from the literal languages of the claims.

**Claims**

1. A method comprising:

   calculating an impedance of an electrical contact (104) based on an electrical signal (103) applied to the electrical contact (104) and a measured electrical signal after passing through the electrical contact (104); and
   determining a condition of the electrical contact (104) using the calculated impedance.

2. The method of claim 1, further comprising determining a change between the applied electrical signal and the measured electrical signal.

3. The method of claim 1 or claim 2, further comprising calibrating the measured electrical signal to a predefined electrical contact condition.

4. The method of claim 1, 2 or 3, further comprising predicting at least one condition of the electrical contact (104) using the calculated impedance.

5. The method of any preceding claim, further comprising using electrical impedance spectroscopy (EIS) to determine or predict the condition.

6. The method of any preceding claim, further comprising determining a phase angle change of the applied electrical signal to identify the condition.

7. The method of any preceding claim, further comprising determining the condition using at least one of:

   a response of the measured electrical signal and at least one of an impedance, a phase angle, a voltage, or a current of the measured electrical signal; and
   at least two of a resistive property, a capacitive property or an inductive property based on the calculated impedance.

8. The method of any preceding claim, further comprising determining a progressive degradation of the electrical contact (104).

9. The method of any preceding claim, further comprising monitoring a plurality of electrical contacts to determine the condition of the contacts.

10. The method of any preceding claim, further comprising predicting the condition based on a predefined model, wherein the predefined model uses at least one of a frequency, an impedance, a phase angle, a voltage, or a current of the measured electrical signal.

11. The method of any preceding claim, further comprising at least one of:

    providing an alarm upon detecting at least one predefined condition; and
    transmitting the measured electrical signal or an indication of the condition to a central monitoring location, wherein the measured electrical signal is used in a circuit breaker switch.

12. The method of any preceding claim, wherein at least one of:

    the condition of the electrical contact is determined in-situ with the electrical contact operatively connected with a circuit;
the applied electrical signal comprises a plurality of frequencies; and
the condition comprises at least one contact property for the electrical contact including at least one of a pitting, an oxide, dust, a carbon, a pressure, or a roughness for the electrical contact.

13. A system (100) comprising:

a receiving unit configured to receive electrical signal information, the electrical signal information including information for an electrical signal (103) applied to an electrical contact (104) and a measured electrical signal after passing through the electrical contact; and
a processing unit (118) configured to calculate an impedance of the electrical contact (104) using the measured electrical signal information to determine a condition of the electrical contact.

14. The system of claim 13, further comprising a signal generator (102) configured to generate the electrical signal (103), wherein the electrical signal generated using at least one frequency different than a frequency of a power signal applied to the electrical contact.

15. A circuit breaker comprising:

one or more pairs of contacts (104);
a signal generator (102) for generating an electrical signal (103) having at least one frequency, wherein the electrical signal is applied to the pairs of contacts (104); and
a processing unit (118) configured to measure the applied electrical signal after the signal passes through the pairs of contacts (104) and determine a change between the applied electrical signal and the measured electrical signal (118), the processing unit further configured to determine an impedance of the pairs of contacts using the change to determine a condition of the pairs of contacts (104).

FIG. 1

FIG. 2

CONTACT REACTANCE VS. FREQUENCY

RESISTANCE ≅ β X FREQUENCY

FIG. 3

FIG. 4

FIG. 5

600

APPLY AN ELECTRICAL SIGNAL HAVING AT LEAST ONE FREQUENCY ACROSS A CONTACT PAIR — 602

RECEIVE THE APPLIED ELECTRICAL SIGNAL AFTER THE SIGNAL PASSES THROUGH THE CONTACT PAIR — 604

MONITOR A CHANGE BETWEEN THE APPLIED ELECTRICAL SIGNAL AND THE RECEIVED ELECTRICAL SIGNAL — 606

DETERMINE A RESISTIVE PROPERTY, INDUCTIVE PROPERTY AND/OR A CAPACITIVE PROPERTY OF THE CONTACT PAIR USING THE RECEIVED SIGNAL — 608

CALIBRATE THE RECEIVED ELECTRICAL SIGNAL TO THE PREDEFINED CONTACT CONDITION — 610

612

USE ELECTRICAL IMPEDANCE SPECTROSCOPY TO DETERMINE OR PREDICT A CONTAT PAIR CONDITION

| DETERMINE THE CONTACT PAIR CONDITION USING A CHANGE BETWEEN THE APPLIED ELECTRICAL SIGNAL AND THE RECEIVED ELECTRICAL SIGNAL | DETERMINE THE CONTACT PAIR CONDITION USING THE DETERMINED RESISTIVE, INDUCTIVE OR CAPACITIVE PROPERTY | DETERMINE THE CONTACT PAIR CONDITION USING THE RESPONSE OF THE RECEIVED ELECTRICAL SIGNAL AND AT LEAST ONE OF AN IMPEDANCE, A PHASE ANGLE, A VOLTAGE, OR A CURRENT OF THE RECEIVED ELECTRICAL SIGNAL |
|---|---|---|
| 614 | 616 | 618 |

PROVIDE A NOTIFICATION UPON DETECTING A PREDEFINED CONTACT PAIR CONDITION — 620

FIG. 6

Europäisches
Patentamt

European
Patent Office

Office européen
des brevets

## EUROPEAN SEARCH REPORT

Application Number

EP 12 18 7661

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 7 148 694 B1 (STABLER MARTIN L [US]) 12 December 2006 (2006-12-12) * the whole document * | 1-15 | INV. G01R31/327 |
| X | EP 2 317 527 A1 (DELPHI TECH INC [US]) 4 May 2011 (2011-05-04) * claims 1,2 * | 1-15 | |
| X | MINOWA I: "INFLUENCE OF DC BIAS ON NONLINEAR DISTORTION OF CONTACTS", ELECTRONICS & COMMUNICATIONS IN JAPAN, PART II - ELECTRONICS, WILEY, HOBOKEN, NJ, US, vol. 71, no. 8, 1 October 1987 (1987-10-01), pages 103-114, XP000098065, ISSN: 8756-663X * the whole document * | 1-15 | |
| X | FR 2 573 212 A1 (THOMSON CSF MAT TEL [FR]) 16 May 1986 (1986-05-16) * claim 1 * | 1-15 | TECHNICAL FIELDS SEARCHED (IPC) |
| X | DI MEIHUA ET AL: "A new method of condition monitoring on electrical contact endurance of power switch", UNIVERSITIES POWER ENGINEERING CONFERENCE, 2004. UPEC 2004. 39TH INTER NATIONAL BRISTOL, UK 6-8 SEPT. 2004, PISCATAWAY, NJ, USA,IEEE, PISCATAWAY, NJ, USA, vol. 1, 6 September 2004 (2004-09-06), pages 93-97, XP010824963, ISBN: 978-1-86043-365-8 * the whole document * | 1-15 | G01R |

-/--

The present search report has been drawn up for all claims

| Place of search | Date of completion of the search | Examiner |
|---|---|---|
| Munich | 19 December 2012 | Dogueri, Ali Kerem |

EPO FORM 1503 03.82 (P04C01)

Europäisches
Patentamt

European
Patent Office

Office européen
des brevets

**EUROPEAN SEARCH REPORT**

Application Number

EP 12 18 7661

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | Jie Shi: "Ageing Condition Inspection System for Electrical Contact Based on Micro-Current Contact Resistance Trend Tracker", 2011 International Conference on Electronic & Mechanical Engineering and Information Technology, 12 August 2011 (2011-08-12), pages 613-616, XP055048372, Retrieved from the Internet: URL:http://ieeexplore.ieee.org/ielx5/59963 64/6022979/06023176.pdf?tp=&arnumber=60231 76&isnumber=6022979 [retrieved on 2012-12-19] * the whole document * | 1-15 | |
| A | YILIN ZHOU ET AL: "Electrical Contact Behavior of Several Typical Materials in Dust at Static and Dynamic Conditions", ELECTRICAL CONTACTS (HOLM), 2010 PROCEEDINGS OF THE 56TH IEEE HOLM CONFERENCE ON, IEEE, PISCATAWAY, NJ, USA, 4 October 2010 (2010-10-04), pages 1-12, XP031788192, ISBN: 978-1-4244-8174-3 * the whole document * | 1-15 | TECHNICAL FIELDS SEARCHED (IPC) |
| A | US 5 999 002 A (FASNACHT GLENN [US] ET AL) 7 December 1999 (1999-12-07) * abstract * | 1-15 | |

The present search report has been drawn up for all claims

| Place of search | Date of completion of the search | Examiner |
|---|---|---|
| Munich | 19 December 2012 | Dogueri, Ali Kerem |

CATEGORY OF CITED DOCUMENTS

X : particularly relevant if taken alone
Y : particularly relevant if combined with another
 document of the same category
A : technological background
O : non-written disclosure
P : intermediate document

T : theory or principle underlying the invention
E : earlier patent document, but published on, or
 after the filing date
D : document cited in the application
L : document cited for other reasons

& : member of the same patent family, corresponding
 document

EPO FORM 1503 03.82 (P04C01)

# EP 2 581 753 A1

## ANNEX TO THE EUROPEAN SEARCH REPORT
## ON EUROPEAN PATENT APPLICATION NO.

EP 12 18 7661

This annex lists the patent family members relating to the patent documents cited in the above-mentioned European search report.
The members are as contained in the European Patent Office EDP file on
The European Patent Office is in no way liable for these particulars which are merely given for the purpose of information.

19-12-2012

| Patent document cited in search report | | Publication date | Patent family member(s) | | Publication date |
|---|---|---|---|---|---|
| US 7148694 | B1 | 12-12-2006 | NONE | | |
| EP 2317527 | A1 | 04-05-2011 | EP | 2317527 A1 | 04-05-2011 |
| | | | EP | 2494564 A1 | 05-09-2012 |
| | | | WO | 2011051067 A1 | 05-05-2011 |
| FR 2573212 | A1 | 16-05-1986 | NONE | | |
| US 5999002 | A | 07-12-1999 | NONE | | |

EPO FORM P0459

For more details about this annex : see Official Journal of the European Patent Office, No. 12/82

17